# EUROPEAN PATENT APPLICATION

(11) **EP 2 602 229 A1**
(43) Date of publication of application: **12.06.2013**
(21) Application number: 11814151.4
(22) Date of filing: 03.08.2011
(51) Int. Cl.: C01F 7/32, B82Y 30/00, C04B 35/00

(54) **METHOD FOR OBTAINING NANOCRYSTALLINE CORUNDUM FROM NATURAL OR SYNTHETIC ALUMS**

(30) Priority: 06.08.2010 ES 201001071
(71) Applicant: Universitat de Valéncia, 46010 Valencia (ES)
(72) Inventor: BASTIDA CUAIRÁN, Joaquín, E-46010 Valencia (ES); IBAÑEZ PUCHADES, Rafael, E-46010 Valencia (ES); URQUIOLA CASAS, María del Mar, E-46010 Valencia (ES); PARDO IBAÑEZ, Pablo Rafael, E-46010 Valencia (ES)
(74) Representative: Illescas, Manuel
(86) International application number: PCT/ES2011/070572
(87) International publication number: WO 2012/017124

(57) **Abstract**

The present invention relates to a process for obtaining nanocrystalline corundum, characterised in that it comprises a first step of thermal treatment of the raw material used in the process at standard pressure, to a temperature greater than that of the last endothermic accident of the differential thermal analysis record of the raw material, performed to 925°C; and a second step of fast cooling from the maximum temperature reached in the preceding step to room temperature. Moreover, the present invention relates to the nanocrystalline corundum obtainable from the process described, as well as to multiple uses of said corundum. Furthermore, this material may be disaggregated, for example by means of high-energy grinding, to produce a fine aggregate that may be used as an abrasive or as a functional load in plastic polymers or other types of materials.

## Description

### Technical field

The present invention belongs to the chemical industry sector. More specifically, it relates to a new process for obtaining nanocrystalline corundum (alpha-alumina) from natural or synthetic alums.

### State of the art prior to the invention

There are various crystalline phases (different polymorphs) with the composition Al₂O₃ which, in addition to their industrial interest in the obtainment of aluminum, are of high technological interest due to their high hardness, wear resistance, resistance to chemical attack, thermal stability and high melting point, properties for which the alpha polymorph (alpha-alumina or corundum) is noteworthy as compared to the rest of alumina polymorphs (Kim et al., 2008, "Influences of precursor and additive on the morphology of nanocrystalline alfa alumina", Journal of Physics and Chemistry of Solids, 69, 1521-1524). As a result of these properties, its primary applications include the use in abrasives, refractories, orthopaedic and dental implants, precious gems and aerospace applications, amongst other possibilities.

In recent years, specific applications are also being developed for nanostructured alumina as a raw material in the manufacturing of monocrystals, special loads for polymers, catalysis, ultrafiltration, etc. (Krell A, Ma H, 1999, Nanocorundum -Advanced synthesis and processing-NanoStructured Materials, 11, 8, 1141-1153).

Corundum (alpha-alumina) appears as a crystalline phase in few natural mineral associations and, more frequently, in artificial associations. In turn, it may be found as a single crystalline constituent, or as a part of mineral associations of ceramic, refractory, abrasive materials, etc. It is also an intermediate product in the production of aluminum, using the Hall-Heroult melting method, from bauxites processed by means of the Bayer method.

In general, it is possible to obtain corundum at standard pressure by means of sol-gel methods, which are based on first obtaining intermediate alumina polymorphs from hydroxide or oxyhydroxide, and said intermediate polymorphs being subsequently transformed by a further thermal treatment. As described in works such as those developed by Kim et al. (previously mentioned), said sol-gel methods make it possible to obtain laminar nanoaluminas which present significant advantages, primarily in functional and structural applications.

Basically, sol-gel methods involve two phases or steps: a first step, wherein corundum is produced, and a second step, wherein the material is disaggregated. In the first step, the corundum is obtained using aluminum hydroxide as the starting material. Once the corresponding sol is prepared, crystalline phases are added thereto which operate as crystal seeds. Subsequently, a desiccation step is performed and, eventually, a further thermal treatment is conducted at a relatively low temperature, in order to subsequently perform a thermal treatment at a higher temperature, until the alpha-alumina is obtained. In the second step, the alpha-alumina obtained is disaggregated, frequently by using suspensions that prevent the aggregation of particles, and the final product may be obtained by means of processes such as atomisation, centrifugation or vacuum filtration, with or without surface treatment.

Thus, for example, application US2004184984 relates to the production of alpha-alumina from various precursors such as ammonium alum. The process includes the preparation of a suspension of the precursor material seeded with "seeds" conveniently dispersed in said suspension. Once the water is removed from the suspension by means of filtration and drying, the material is subjected to a calcination step at a temperature ranging between 600°C and 890°C, until alpha-alumina is finally obtained.

On the other hand, patent US7022305 discloses the obtainment of primary corundum particles from an aqueous solution of aluminum nitrates or chlorides with crystal seeds, subsequent calcination, separation of salts and a new calcination at 700°C-975°C, followed by a final fractionation process.

In turn, in the patent literature we may find processes for obtaining alumina from minerals. Thus, ES443069 discloses a process for obtaining alumina from clays and other aluminous products, which involves successively subjecting the mineral to conditioning (activation and grinding), disaggregation in diluted sulfuric acid and dilution and separation of sludges, to produce a clear liquid that is cooled and saturated with hydrochloric acid in order to precipitate hydrated aluminum chloride crystals, which are calcinated to obtain alumina.

Unlike the aforementioned methods, the present invention relates to a new process for obtaining corundum with a low crystallinity (nanocrystalline) in the lower portion of the corundum formation segment recognised in the thermal decomposition of alums (hereinafter, this term is used to refer to aluminum sulfate; sulfate with the formula MAl(SO₄)₂; mixtures of aluminum sulfate and at least one sulfate with the formula MAl(SO₄)₂; and mixtures of different sulfates with the formula MAl(SO₄)₂; where M is a monovalent cation, and the monovalent cation is preferably selected from the group formed by Na, K, Rb, Cs, NH4 and Tl, and Al is aluminum), in the solid state at standard pressure (Apte NG et al., 1988a, "Kinetic Modelling of Thermal Decomposition of Aluminium Sulfate", Chem. Eng. Communications, 74, 47-61; and Apte NG et al., 1988b, "Thermal decomposition of aluminium-bearing compounds", Journal of Thermal Analysis, 34, 4, 975-981). In this way, by means of direct sintering at an adequate temperature (greater than 900°C) and standard pressure, it is possible to prevent the formation of low-temperature alumina polymorphs (called intermediate aluminas), which, in the event that they have previously formed, result in an alpha-alumina phase (corundum) with a higher density.

Furthermore, the thermal treatment (or sintering) at temperatures greater than 900°C makes it possible to perform the process whilst avoiding the use of acid or alkaline treatments, before or after obtaining the solid sintered product, thereby distinguishing the process from those traditionally used for obtaining alumina from alunites (see, for example, that disclosed in patent ES443069).

Another distinctive feature of the process of the invention, as compared to other processes in the state of the art, is its simplicity, since it allows for the use of raw materials from mineral deposits of the group of alums or products derived from the dehydration thereof (or artificial phases with an equivalent composition), or minerals such as alunite or natroalunite (or solid solutions of said minerals), as well as products of the partial or total dehydration and/or dehydroxylation thereof, which, through thermal processing above 900°C at standard pressure, produce corundum. These alunite mineral deposits have been occasionally used in the production of alumina and, at present, are practically not used at all, since, as is well-known, practically all the alumina is obtained by means of the Bayer method. Thus, unlike other processes based on the use of solutions or sol-gel processes, the present process uses raw materials (natural or synthetic) in the solid state, which do not require special grinding or previous melting, and may be directly incorporated into the thermal treatment as dross or pulverised. This simplicity of the process makes it more easily adaptable to industrial mass-production processes.

Moreover, the process of the invention makes it possible to obtain a product with a nanocrystalline nature, composed of tabular- or plate-shaped primary nanoparticles in porous microcrystalline aggregates, which facilitates the subsequent disaggregation process thereof into powders that have an immediate application as ultra-fine abrasives and as loads (or fillers) in plastics or other types of materials. This characteristic represents a significant advantage of the product of the invention, since compact corundum is a hard, difficult-to-grind material.

### Description of the invention

Therefore, the present invention relates to a new process for obtaining nanocrystalline corundum (alpha-alumina), characterised in that it comprises:
(a) a first step involving thermal treatment, at standard pressure, of the raw material used in the process, to a temperature greater than that of the last endothermic accident, from the differential thermal analysis (DTA) record of the raw material, performed to 925°C;
(b) a second step involving fast cooling from the temperature reached in step (a), to room temperature.

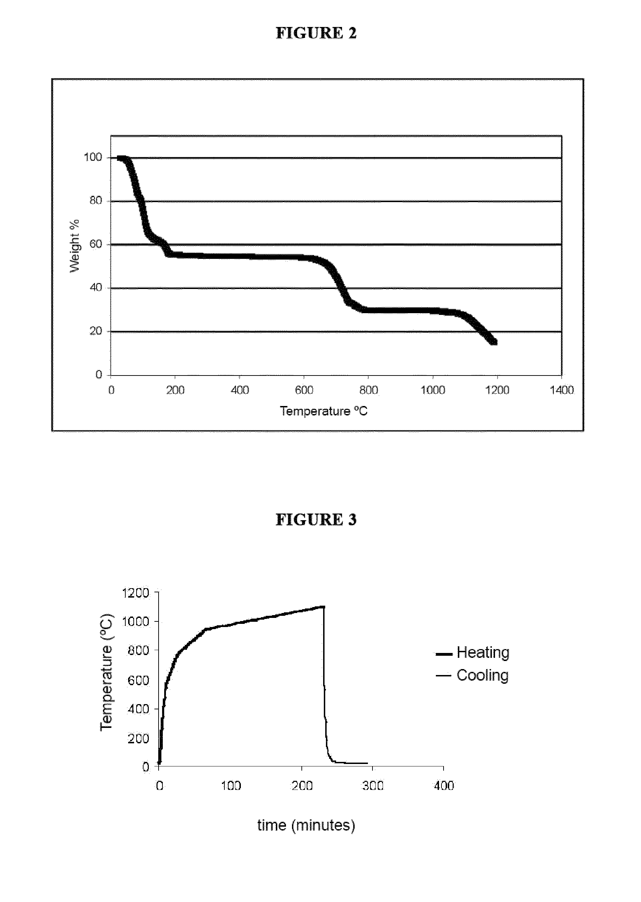

Step (a), of thermal treatment or sintering of the raw material used in the process, is performed by means of any known heating process and, preferably, using fixed or rotary ovens, continuously or discontinuously, and without the need to use controlled atmospheres. When performing said step (a), of thermal treatment of the raw material used in the process, it is possible to use the thermal analysis interpretation results provided in the works by Apte et al. [Apte NG et al., 1988a, "Kinetic Modelling of Thermal Decomposition of Aluminium Sulfate", Chem. Eng. Communications, 74, 47-61, and Apte NG et al., 1988b, "Thermal decomposition of aluminium-bearing compounds", Journal of Thermal Analysis, 34, 4, 975-981]. As may be observed in said works, depending on the composition of the raw material used in the process, the temperature of the thermal treatment may be reduced, provided that it is greater than that corresponding to the last endothermic accident observed in the differential thermal analysis (DTA) record of the raw material used in the process, performed to 925°C, and verifying, by means of X-ray diffraction (XRD), the disappearance of alum phases (the latter being characterised in that they comprise sulfate and alumina). In general, said temperature ranges between 750°C and 925°C, in an interval of mass constancy, as shown in the thermogravimetric record (mass-temperature) of Figure 2 attached to this description.

Preferably, it is advisable to follow up the thermal treatment, by means of X-ray diffraction (XRD) analysis of the mineralogical composition of the products resulting from said treatment, in order to select a temperature and sintering ramp such that the only products are corundum and soluble sulfates. In general, the sintering ramp may be developed in two sections: the first, and faster one, where the drying or dehydration of the alums used as a raw material takes place, and a second section, which may be developed at a faster or slower rate depending on the microstructural development that is considered to be most adequate for the expected use of the nanocrystalline corundum obtained in the process.

On the other hand, step (b), of fast cooling (or quenching) of the product obtained after step (a), is responsible for the nanocrystalline character of the final product (corundum) of the process, as well as the final morphology thereof, which is generally laminar or tabular.

In general, this step (b) entails a decrease in temperature from a temperature greater than that of the endothermic accident with the highest temperature recorded in the differential thermal analysis (DTA) of the raw material used in the process, generally ranging between 750°C and 925°C, to room temperature. In particular, this room temperature may be less than 55°C, and generally ranges between 20°C and 30°C, since this is the habitual temperature range in laboratories or plants located in areas with a mild/warm climate. However, under special conditions, it is possible to take the cooling to lower temperatures, even below 0°C.

Depending on the technique used for the cooling, the quenching rate may be equal to or greater than 0.2°C/s, preferably equal to or greater than 1.7°C/s, and, more preferably, equal to or greater than 30°C/s.

In a preferred embodiment of the invention, said quenching step (b) may be performed by air extraction, and it is sufficient to use an average rate equal to or greater than 1.7°C/s from the sintering temperature to an approximate temperature of 55°C, and an average rate equal to or greater than 0.2°C/s from the sintering temperature to an approximate temperature of 22°C.

Furthermore, in an even more preferred embodiment of the invention, said fast cooling (or quenching) may be performed by extraction and immersion in water, preferably at room temperature, and a rate equal to or greater than 30°C/s may be achieved. Preferably, the quantity of water used in the immersion is that corresponding to a solid-water weight ratio less than or equal to 1%. Moreover, the cooling by means of quenching by pouring in water facilitates concentration of the corundum, since it makes it possible to dissolve the soluble co-products obtained in step (a), in the event that they are present, in the cooling water, as described further below.

In additional particular embodiments of the invention, it is possible to perform the cooling such that higher cooling rates are achieved, such as, for example, by means of extraction and immersion in mixtures of water and ice at 0°C, in aqueous solutions under conditions of cryoscopic decrease of the freezing temperature, in liquefied gases, or in any other non-flammable fluid at a temperature equal to or lower than room temperature. Moreover, it is also possible to perform the quenching by means of high-temperature spraying of the product obtained in step (a) on at least one fixed or moveable surface of a chemically inert material, preferably a material with high thermal conductivity and, more preferably, a metal. Said surface may be used at room temperature or a lower temperature, if it is cooled by means of an adequate process.

As raw materials for the process, it is possible to use alums, which, as is well-known, are decomposed when subjected to a sufficiently high temperature, to produce alpha-alumina (corundum).

In a preferred embodiment of the invention, the alum used as a raw material may involve an alum selected from a group preferably formed by potassium alum (potassium aluminum sulfate), hydrated or hydroxylated potassium aluminum sulfate, sodium alum (sodium aluminum sulfate), hydrated or hydroxylated sodium aluminum sulfate, potassium-sodium alum, ammonium aluminum sulfate, and hydrated or hydroxylated ammonium aluminum sulfate, as well as any combination thereof. Said alum may be composed of synthetic alums or natural alums, as well as any combination thereof. Synthetic alums, obtained from an industrial synthesis process, may additionally comprise soda, potash, ammonia or other components, and may be supplied in dross or powder. On the other hand, natural alums may be composed of at least one mineral, preferably selected from alunite (KAl₃(SO₄)₂(OH)₆), natroalunite (NaAl₃(SO₄)₂(OH)₆), or mixtures of sulfates containing alumina and potash, or alumina and soda, amongst other possibilities, as well as any combination thereof.

In this way, the process described is adequate both for obtaining corundum on a small- or large-scale from synthetic raw materials, and for obtaining corundum on a large scale using natural alums, understanding these minerals to be those the composition whereof includes cationic aluminum and sulfate anion. Amongst the latter, those with compositions close to that of alunite [KAl₃(SO₄)₂(OH)₆] are especially preferred, since they generate alkaline aluminum sulfates by dehydroxylation at a variable temperature between 480°C and 590°C, depending on the sodium content present in the alunite. Moreover, it is worth noting that the invention has the additional advantage of the existing availability of alunites, of which there are important deposits, for example, in the US and the former USSR countries, whilst minor deposits have also been found in Spain.

On the other hand, the natural alums selected may be used with a greater or lesser degree of fragmentation. Moreover, in the event that natural materials of this type are selected as the raw material, it is possible to ensure the efficiency of the process by adequately controlling the composition thereof, preventing masses contaminated with phyllosilicates, silicates and other inadequate minerals, whilst, at the same time, controlling the microstructural characteristics of the final product obtained. Said control may be performed using techniques such as microstructural analysis by X-ray diffraction or field emission electron microscopy.

In a particular embodiment of the invention, it is possible to use, as raw materials, materials from natural alunite deposits, and said deposits may contain variable quantities of impurities such as quartz and phyllosilicates (minerals from the kaolinite group being the most frequent amongst the latter). Likewise, the useful substance in these deposits may be composed of one or several mineral alums, preferably selected from the groups of minerals indicated below:
• Alunite group:

| | |
|---|---|
| Alunite | KAl₃(SO₄)₂(OH)₆ |
| Natroalunite | NaAl₃(SO₄)₂(OH)₆ |
| Natrojarosite | NaFe₃(SO₄)₂(OH)₆ |
| Jarosite | KFe₂(SO₄)₂(OH)₆ |
| Ammonium-jarosite | NH₄Fe₃(SO₄)₂(OH)₆ |
| Hydronium-alunite | H₃O.Al₃(SO₄)₂(OH)₆ |
| Minamiite | Ca_{0.5}Al₃(SO₄)₂(OH)₆ |

• Alum group (alums):

| | |
|---|---|
| Tamarugite | NaAl(SO₄)₂·6H₂O |
| Mendozite | NaAl(SO₄)₂·11H₂O |
| Kalinite | NaAl(SO₄)₂·11H₂O |
| Potassium alum | KAl(SO₄)₂··12H₂O |
| Sodium alum | NaAl(SO₄)₂·12H₂O |
| Ammonium alum (tschermigite) | NH₄Al(SO₄)₂·12H₂O |

• Alunogen group:

| | |
|---|---|
| Aluminite | Al₂SO₄(OH)₄·7H₂O |
| Alunogen | Al₂(SO₄)₃·17H₂O |
| Lapparentite | Al₂SO₂(OH)₂·9H₂O |
| Basaluminite | Al₂SO₄(OH)₁₀·5H₂O |
| Felsobanyite | Al₂SO₄(OH)₁₀·5H₂O |
| Paraluminite | Al₂SO₄(OH)₁₀·5H₂O |

• Others:

| | |
|---|---|
| Melanterite | FeSO₄·7H2O |
| Szomolnokite | FeSO₄·H₂O |
| Rhomboclase | FeH(SO₄)₂·4H₂O |
| Paracoquimbite | Fe₂(SO₄)₃·9H₂O |
| Coquimbite | Fe₂(SO₄)₃·9H₂O |
| Jurbanite (*) | AlOHSO₄ |

Amongst the different possible combinations, those corresponding to minerals from the alum group (or the total or partial dehydration or dehydroxylation products thereof) and alunite-natroalunite combinations are especially preferred for the process of the invention, with different degrees of dehydration and/or dehydroxylation of said minerals being admitted.

Depending on the type of raw material used in the process, in addition to alumina, it is possible to obtain at least one water-soluble phase, which is not obtained when the raw material is only composed of ammonium aluminum sulfates or hydrated or hydroxylated ammonium aluminum sulfates.

Thus, in a particular embodiment of the invention, wherein water-soluble sulfates, such as, for example, alkaline sulfates (generally, potassium sulfate or potassium-sodium sulfate), are generated as co-products of the thermal transformation of the raw material used in the process, the process may, in turn, comprise a further step of elimination of said sulfates. This step, which entails concentration of the final product, may be preferably performed by dissolving the product obtained after the quenching step in excess water. In this way, in a particular embodiment wherein the temperature is equal to or greater than 20°C, the quantity of water used may be more than 10 times that of soluble sulfate, if the latter is potassium sulfate, and the necessary quantity of water may be estimated as a function of the nature of the sulfate present, the quantity thereof and the temperature, in accordance with available data; for example, in Lide D.R, editor, "CRC Handbook of Chemistry and Physics", 90th Edition, Internet 2010 Version, pages 8-114 and following, CRC Press.

Following the dissolution step, the solution may be eliminated by filtration, centrifugation or any other liquid-solid separation technique. In this way, it is possible to obtain, on the one hand, the insoluble product (corundum) and, on the other, the solution of, at least, one soluble sulfate that may have been generated as a co-product of the thermal transformation of the raw material in the process. In turn, said sulfate may be recovered, preferably by crystallisation of the liquid phase.

The correct elimination of the sulfates from the final nanocrystalline corundum product, prior to the drying thereof, may be easily verified by the addition of at least one barium salt in the last washing waters. In this way, if no barium sulfate precipitate is generated, the elimination of the sulfates may be considered to be completed.

In a particular embodiment of the invention, wherein the quenching step is performed by pouring in water the sintering or thermal treatment product of the raw material used in the process, the separation of the soluble sulfates may be performed simultaneously with the fast cooling (or quenching) step. Thus, in addition to the concentration of the corundum in the solid phase as a result of the dissolution of the potential sulfate or sulfates obtained as co-products of the thermal treatment of the raw material in the cooling water, the cooling process is favoured by the heat absorption that occurs when the soluble co-products are dissolved.

Once the process is completed, the nanocrystalline corundum is obtained in the form of porous microcrystalline aggregates of primary nanoparticles with a tabular or plate shape. These porous aggregates may have an approximately spherical shape, more or less deformed, frequently perforated and sometimes fragmented.

In general, it is possible to control the growth of the primary corundum nanoparticles as a function of the cooling rate of the process. Thus, it is possible to prolong the growth if a slow cooling is performed, whereas, when the cooling is fast, it is possible to block the growth and additionally produce, by thermal shock, fracturing of the aggregates, and even of the primary nanoparticles.

The porous character of the microcrystalline aggregates of primary corundum nanoparticles represents a significant advantage of the invention, since it facilitates the subsequent disaggregation process, unlike what happens with compact corundum products, which, due to their non-porous nature, are difficult to grind as a result of their hardness and tenacity.

In order to verify the nanocrystalline character of the product obtained, it is advisable to use adequate techniques, preferably microstructural analysis by X-ray diffraction and high-magnification field emission electron microscopy.

A further object of the invention is the use of the nanocrystalline corundum obtained from the process described by means of an additional sintering step (which entails the re-crystallisation thereof), in order to obtain refractory products, whether shaped or unshaped. To this end, in a particular embodiment of the invention, the nanocrystalline corundum may be poured on at least one support, preferably at room temperature, and, therewith, or moving thereon, may be immediately introduced into at least one oven, wherein it is re-crystallised, at a temperature greater than room temperature and lower than the melting temperature, such that, the higher the re-crystallisation temperature, the lesser time required for the re-crystallisation. This additional sintering cycle may be performed with or without prior disaggregation, grinding and concentration of the corundum, and may constitute an intermediate step in the process for producing at least one refractory product, whether shaped or unshaped. In this way, in the interval of introduction into the oven, the corundum may be compressed using an adequate device prior to the sintering, or may be compressed inside the oven.

A further object of the invention is the use of the nanocrystalline corundum obtained from the process described directly as a nanocrystalline corundum aggregate without subsequent disaggregation, susceptible to being used in very varied applications, such as, for example, production of mortars by direct addition to cement pastes or other binders, incorporation into ceramic pastes by pouring in barbotine, use as a filtrating aggregate or as a catalysis support, etc. Moreover, it may also be used following a partial or total disaggregation step, resulting in nanoparticle corundum powder. In this case, the progressive disaggregation may generate fine aggregates, and even very fine aggregates, where the primary nanoparticles are predominantly loose.

Consequently, in a further embodiment of the invention, the process described may in turn comprise a subsequent disaggregation and granulometric fractionation step, preferably by means of high-energy grinding, to produce nanoparticles with an elongated shape (shape of a plank or elongated tabular shape), or a plate shape (non-elongated tabular shape, with two dimensions predominating with respect to a third dimension corresponding to the thickness) or an equidimensional shape (without a clear predominance of any dimension). Said grinding step may be performed by means of dry grinding or wet grinding processes, high-shear treatment of suspensions, sonofragmentation or other similar processes. In general, the primary corundum nanoparticles obtained are of a nanometric magnitude, determined by the presence of predominant initial thicknesses of less than 100 nm, and appear in microcrystalline aggregates that constitute a fine aggregate the granulometric distribution whereof preferably presents a content of less than 10% of aggregates with a size greater than 50 microns. In the event that the fast cooling is performed by water-quenching, the maximum frequency in the granulometric distribution is below 30 microns, without performing any grinding whatsoever, and a fine aggregate with aggregates having a size greater than 20 microns is easily obtained by disaggregation.

A further object of the invention is the application of the aforementioned fine aggregates as ultrafine abrasives or functional loads for plastic polymers or other types of materials, providing them with hardness and abrasion resistance, and reducing the thermal expansion coefficient thereof.

### Brief description of the figures:

### Figures relative to Example 1

- **Figure 1** shows diffractograms of the alum used as a raw material, where:
   • Lines with label A - ICDD card 018-0989: KAl(SO₄)₂•6H₂O,
   • Lines with label B - ICDD card 018-0990: KAl(SO₄)₂•3H₂O,
   • Lines with label I - ICDD card 007-0017: KAl(SO₄)₂•12H₂O.
- **Figure 2** shows a DTG graph of the desiccated raw material.
- **Figure 3** shows the temperature-time curve corresponding to the sintering and subsequent air-quenching performed in Example 1.
- **Figure 4** shows diffractograms of successive reaction and quenching products (at 574°C, 900°C and 1100°C), as well as the product of quenching at 1100°C following dissolution of the soluble co-product in water:
   • Lines with label A - Card 023-0767: KAl(SO₄)_{2,}
   • L i n e s with label B - Card 027-1337: K₃Al(SO₄)₃/1.5K₂SO₄•0.5Al₂(SO₄)₃,
   • Lines with label I - Card 044-1414: K₂SO₄,
   • Lines with label C - Card 074-1081: Al₂O₃-corundum.
- **Figure 5** shows larger crystals recognisable in the product of air-quenching from 1100°C.
- **Figure 6** shows the nanostructured appearance of the larger corundum crystals of the product of air-quenching from 1100°C, following the separation thereof from the solubilised sulfate.
- **Figure 7** shows the product of air-quenching from 1100°C, following separation of the solubilised sulfate, and subsequent grinding for 6 seconds in a high-energy disc mill with tungsten carbide elements.
- **Figure 8** shows the nanostructured appearance of the larger corundum crystals of the product of air-quenching from 900°C, following the separation of the solubilised sulfate.
- **Figure 9** shows the granulometry of the corundum sample of the product of air-quenching from 1100°C, following the separation of the solubilised sulfate.
- **Figure 10** shows the granulometry of the corundum sample of the product of air-quenching from 900°C, following the separation of the solubilised sulfate.

### Figures relative to Example 2

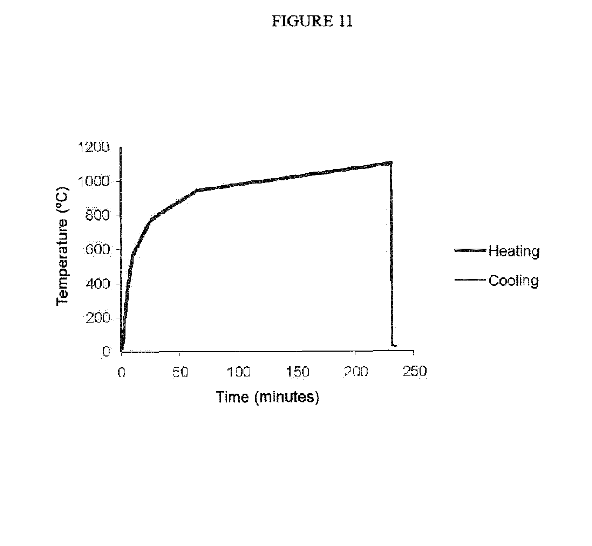

- **Figure 11** shows the temperature-time graph of the thermal treatment and quenching corresponding to the experiment described in Example 2.
- **Figure 12** shows diffractograms of the product of the thermal treatment at 1100°C and water-quenching of the additional experiment described in Example 2, where:
   • Lines with label A - Card 044-1414: K₂SO₄,
   • Lines with label B - Card 074-1081: Al₂O₃-corundum.
- **Figure 13** shows the nanostructured appearance of the corundum aggregates of the product of water-quenching from 1100°C, following the separation of the solubilised sulfate.
- **Figure 14** shows a detail of the nanocrystalline corundum plates of the product of water-quenching from 1100°C, following separation of the solubilised sulfate.
- **Figure 15** shows a detail of an aggregate with larger-size nanocrystalline plates in the product of water-quenching from 1100°C, following the separation of the solubilised sulfate.
- **Figure 16** shows a detail of the thickness of the most frequent crystals in the product of water-quenching from 1100°C, following the separation of the solubilised sulfate.
- **Figure 17** shows the granulometry of the corundum sample of the product of the thermal treatment (or sintering) at 1100°C and water-quenching, following separation of the solubilised sulfate.

### Figures relative to Example 3

- **Figure 18** shows the results pertaining to Example 3. Specifically, they correspond to the diffractograms of the raw material (natroalunite-alunite) and the product of sintering at 1100°C with air-quenching:
   • Lines with label I - Card 041-1467: Natroalunite, NaAl₃(SO₄)₂(OH)₆,
   • Lines with label A - Card 072-1630: Alunite, KAl₃(SO₄)₂(OH)₆,
   • Lines with label C - Card 20-0927: KNaSO₄,
   • Lines with label B - Card 010-0173 Al₂O₃-corundum.

### Examples:

Below we record, as examples and for non-limiting purposes, a set of particular embodiments of the process of the invention. In particular, the processes described in Examples 1 and 2 were developed for the separation of α alumina from dehydrated potassium alum, which may be synthetic or obtained from natural raw materials whereof there may be important deposits. However, said embodiment examples may be extended to the use of other alums as raw materials, particularly alum with sodium (Example 3), which, as previously indicated, is usually associated with alunite in mineral deposits.

### Example 1

The following example is intended to describe a particular embodiment of the process of the invention without, however, limiting it to the operating conditions described.

### Raw material:

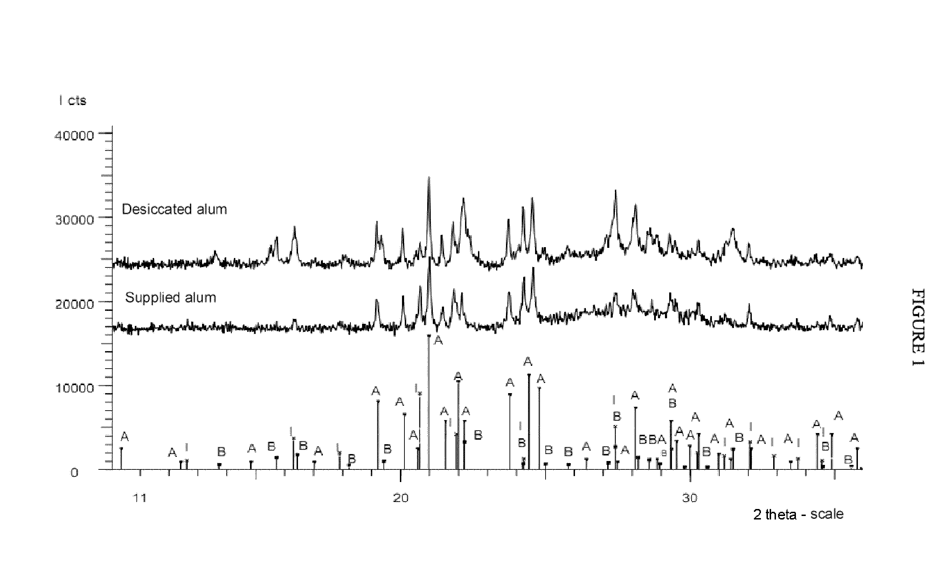

As a raw material for the process, commercial hydrated potassium aluminum sulfate was used, subjected to desiccation in a forced-air oven at 35°C for 24 hours. Figure 1 shows the diffractometric records of the commercial raw material and the raw material desiccated at 35°C for 24 hours in a forced-air oven, the predominant constituents whereof are potassium alum hexahydrate and dodecahydrate (KAl(SO₄)₂•6H₂O and KAl(SO₄)₂•12H₂O), and potassium alum trihydrate and dodecahydrate (KAl(SO₄)₂•3H₂O and KAl(SO₄)₂•12H₂O).

Figure 2 shows the thermogravimetric analysis of the desiccated raw material, recorded between normal temperature and 1200°C.

### Process:

### 1. Thermal treatment:

The thermal treatment, to a maximum temperature of 1200°C, was performed in a laboratory electric muffle furnace.

In the obtainment example, 10 g of the aforementioned raw material, contained in a porcelain crucible, were treated at the temperatures indicated in Table 1, using the sintering and cooling ramp recorded in Figure 3. In this way, once the maximum sintering temperature was reached, a fast cooling, or quenching, was performed by extracting the sample from the oven, with the exterior of the oven at room temperature. Table 2 shows the record of successive cooling times.

Figure 3 shows the temperature-time curve for the sintering and cooling performed (where the sintering record was obtained by means of a Conatec 4801 oven controller and the cooling record was obtained by means of a Lufft C120 temperature reader with a type K thermocouple).

**Table 1. Successive times from the beginning of the heating**

| Temperature in the heating ramp (°C) | Time elapsed from the beginning of the sintering (minutes) |
|---|---|
| 570 | 3 |
| 900 | 48 |
| 1100 | 177 |

**Table 2. Temperature-time for air-quenching**

| Temperature interval (°C) | Successive times from the beginning of the quenching (minutes) |
|---|---|
| 1100-584 | 1 |
| 584-56 | 9 |
| 56-22 | 52 |

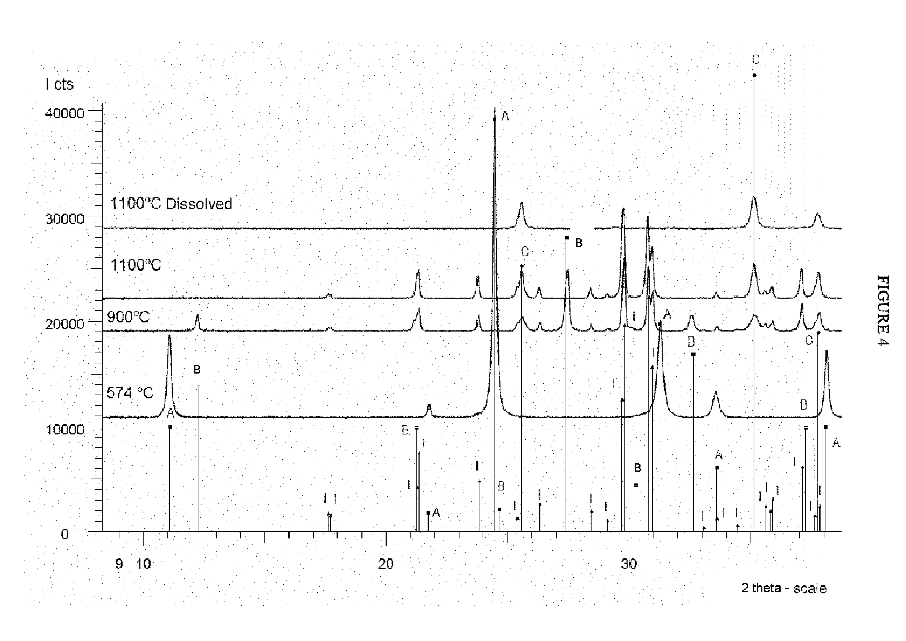

Figure 4 shows the evolution of the mineralogical composition at three control points for the sintering performed, by means of the diffractograms of disoriented powder of the materials obtained by quenching at the temperatures of 570°C, 900°C and 1100°C, as indicated in Table 1.

The diffraction records were obtained by means of the crystalline powder method, using a Bruker D8 X-ray diffraction equipment operating under the Difrac Plus system, which controls the operating conditions and includes programmes for the evaluation of the records, maintenance of the ICDD database, identification of phases and semi-quantitative estimation thereof.

At a temperature of 1110°C, it may be observed that the thermal transformation product is composed solely of potassium sulfate and corundum.

### 2. Selection of the processing conditions:

The diffractograms in Figure 4 show that, at 570°C, the only crystalline phase present is dehydrated alum [KAl(SO₄)₂]. Said quenching point (570°C) in Table 1 is a good representation of the final composition reached in the second interval (200°C-600°C) of the TGA of Figure 2, whereas the quenching points at 900°C and 1100°C are already in the lower echelon of said TGA.

The 900°C temperature is above the high-temperature endothermic maximum in the DTA of alum (Figure 3B in Gad GM (1950), "Thermochemical changes in alunite and alunitic clays", J. Amer. Ceram. Soc. 33, 6, 208-210), but the endothermic peak does not conclude until a temperature close to 950°C. For this reason, in the diffraction record for quenching at 900°C, the presence of small quantities of a sulfate containing aluminum is identified, whereas this does not occur at 1100°C.

The FWHM values (full width at half-maximum diffraction peak) at 900°C and 1100°C, for the corundum 104 reflection (2.56 Å; 35.1° (2θ) in Cu Kα radiation), are 0.281 and 0.214° (2θ), respectively, which reflects an increase in crystallinity. Said crystallinity may be reduced by means of shorter sinterings or sintering at a lower temperature, but greater than that of completion of the endothermic maximum.

Depending on the heating rate, the presence of potassium sulfate and corundum as the only phases present may be obtained at a different temperature, which may be demonstrated by means of diffractometric records.

The same process would be followed with other alums that may be used as a raw material, taking the decomposition temperatures established in the works by Apte et al. as a reference [Apte et al. (1988a), "Kinetic Modelling of Thermal Decomposition of Aluminium Sulfate", Chem. Eng. Communications, 74, 47-61, and Apte NG et al. (1988b), "Thermal decomposition of aluminium-bearing compounds", Journal of Thermal Analysis, 34, 4, 975-981], and making additional verifications by means of X-ray diffraction analysis of the quenching products.

### 3. Separation of the corundum

The cooled product obtained by sintering at 1100°C and air-quenching was subjected to stirring (in distilled water in a weight proportion of 1‰) for sixty hours at room temperature. Subsequently, the solution was separated by means of vacuum filtration on Albet filter paper (60 g/m²) (RM14034252).

The upper diffractogram, labelled as "1100 dissolved" in Figure 4, corresponds to the product obtained following the separation of the solubilised potassium sulfate.

It may be observed that the record shows the characteristic corundum reflections, and only a small peak is observed corresponding to the maximum-intensity spacing of potassium sulfate, close to 30° (2θ), due to the presence of small quantities of said phase (evaluated to be less than 1% by weight using the reference intensity method, applied with the semi-quantitative analysis tool of the Diffrac Plus programme, Evaluation Package, EVA v.9, from Bruker AXS, 2003, used for the evaluation of the diffractometric records performed in a Bruker D8 equipment).

### Results:

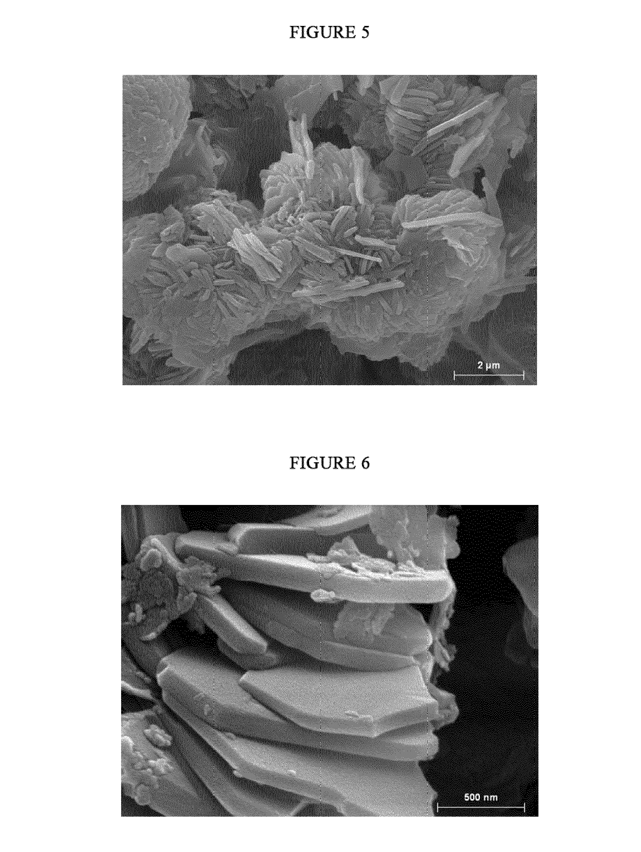

Figures 5 to 8 correspond to images obtained by high-magnification field emission scanning electron microscopy (FESEM) (Hitachi 4100 equipment, operating at a voltage of 30 kV and an extraction potential of 10 keV; metallisation of the powder in the sample holder prior to observation by means of vacuum gold plating with a Biorad RC500 equipment), which demonstrate the nanocrystalline character of the corundum obtained. Figure 5 shows the texture of the product of quenching at 1100°C, which is composed of microcrystalline aggregates with larger pores around which nanotextured corundum plates are arranged, as shown in the detail in Figure 6, corresponding to the larger corundum plates, the greatest dimension whereof does not exceed 1000 nm and the maximum thickness whereof is less than 200 nm.

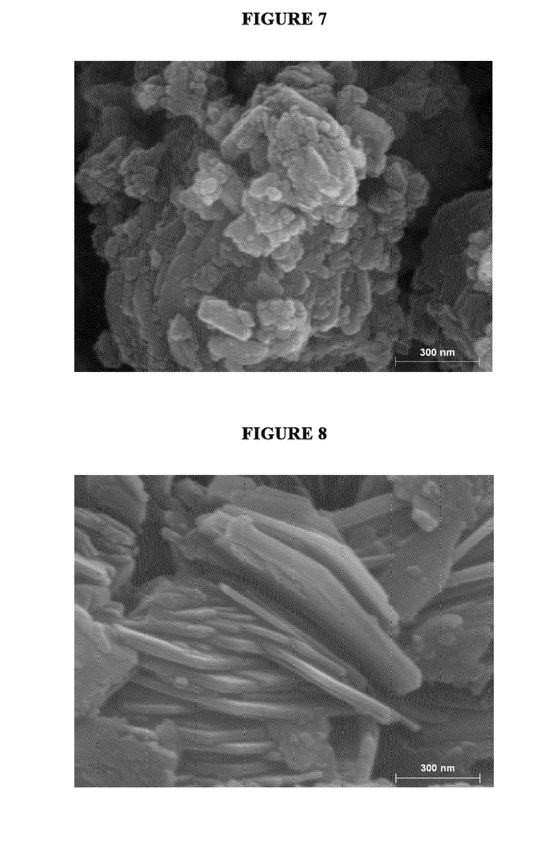

Figure 7 corresponds to the preceding material subjected to fast high-energy grinding (10 g of quenching material subjected to grinding for 6 seconds in a Fristch Pulverisette 9 oscillating disc vibratory mill, with elements - jar, lid, crown and internal cylinder - made of steel with a tungsten carbide coating).

The larger particles show a greater dimension of less than 200 nm, being predominantly less than 70 nm.

Figure 8 corresponds to the product of quenching from 900°C, showing corundum plates with a greater edge of less than 600 nm and apparent thicknesses (determined by exfoliation dimensions or lines parallel to the pinacoidal faces ({0001}) of less than 75 nm.

This demonstrates the possibility of reducing the size of the corundum plates as a function of the sintering conditions (temperature and time), as well as reducing the size of the particles, in a grinding process that is favoured by the microporosity of the microcrystalline aggregates.

X-ray diffraction microstructural characterisation methods analogous to those used in Pardo P. et al. (2009), "X-ray diffraction line broadening study on two vibrating, dry milling procedures in kaolinites", Clays and Clay Minerals 57, 1, 25-34, for the case of aggregates of nanocrystalline kaolinite, may be used to control the size of the nanocrystalline corundum crystallite produced by quenching, as well as the subsequent products of the fragmentation thereof by different routes.

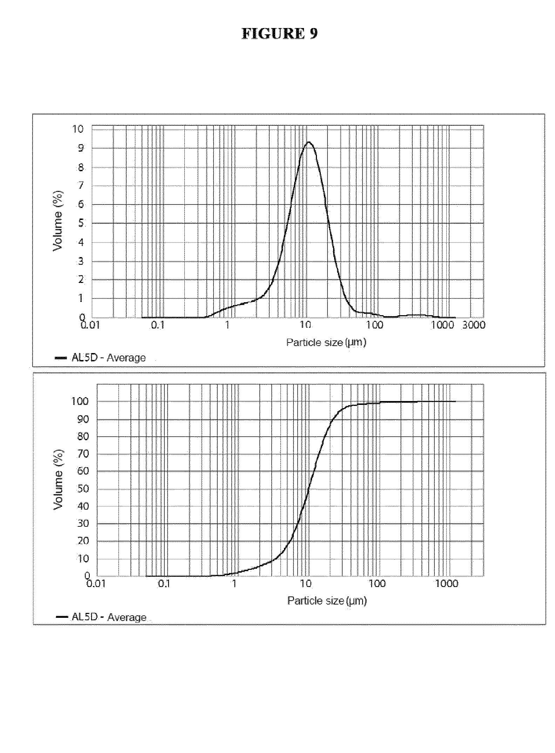

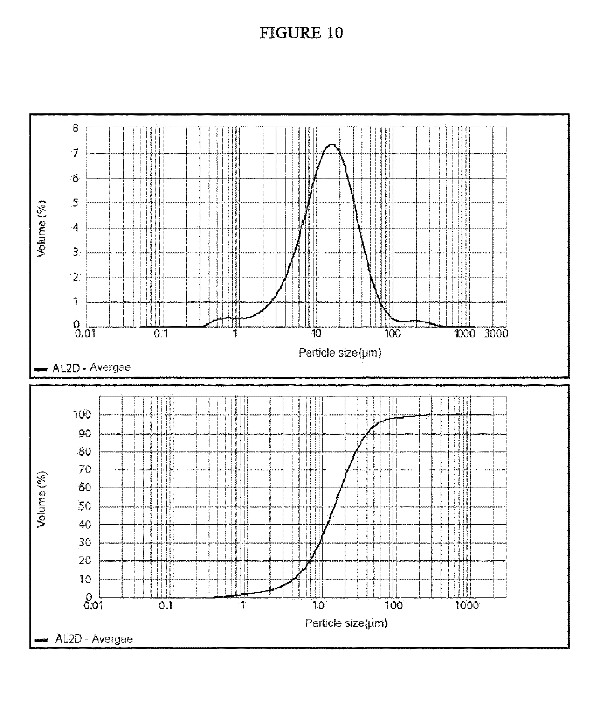

The granulometric distributions (obtained by laser diffraction) recorded in Figures 9 and 10 show the state of aggregation of the products whereto Figures 6 and 8 refer.

Given its granulometric distribution (more than 97% below 75 µm), composition (corundum, alpha-alumina) and texture (aggregates of nanometric crystals), the product obtained may be considered to be a nanocorundum filler.

### Example 2

The object of this experiment was to verify the results obtained using another quenching process, which in this case involves extraction of the sintering product from the oven and immersion in water.

### Raw material:

The raw material for this example was the same as that described in Example 1.

### Process:

In this case, the experiment of Example 1 was repeated, except that the fast cooling was performed by immersion in water, using a solid/water ratio of 1%. Table 3 shows the cooling temperature-time sequence (obtained in the same manner as in Example 1).

**Table 3. Temperature-time for the water-quenching**

| Temperature interval (°C) | Time from the beginning of the quenching (seconds) |
|---|---|
| 1100-38 | 35 |

### Results:

Once the aforementioned process was performed, the solid product obtained following filtration of the granular material obtained by filtration and drying, after pouring the solid in water (initial raw material/water weight ratio = 5‰), was directly analysed.

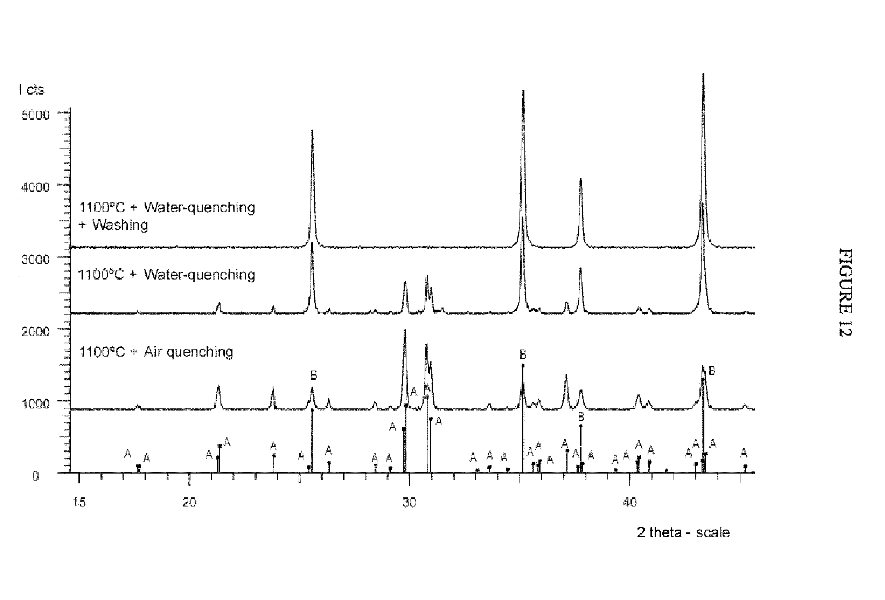

The diffractogram of the material obtained following the process described demonstrates that, as a result of pouring the solid product obtained by sintering in water, a significant portion of the sulfate produced is dissolved (see Figure 12, which shows lower intensities of the potassium sulfate peak and higher intensities of the corundum peak) as compared to the product obtained by air-quenching (also represented in the same figure for comparison purposes).

The corundum content of the water-quenching product is 61.4%, as compared to 39% for the product obtained by air-quenching (estimates by the same process as that described in Example 1). It is worth noting that, in the case of water-quenching, the product analysed was the air-dried solid product, following decanting of the water used for the quenching, and without having performed an additional washing to complete the dissolution of the soluble co-product.

Observations of the corundum by means of FESEM were performed in concentrates obtained as described in Example 1, but without performing a subsequent high-energy grinding.

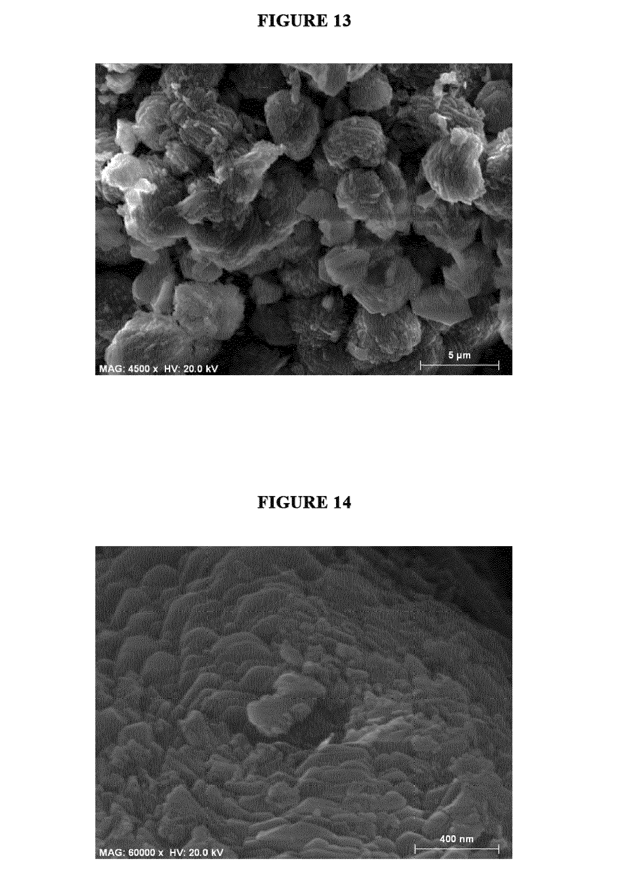

Figure 13 shows an FESEM image that presents the general appearance of the aggregates of corundum crystals obtained (note the porous character of the crystalline aggregates, which appear in the central orifice of the globular-shaped aggregates).

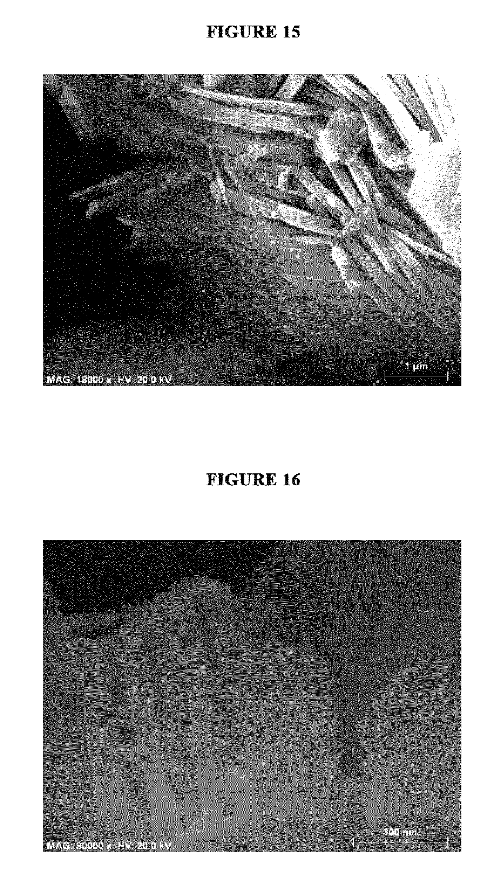

Figures 14 and 15 collect FESEM images corresponding to the plates with the most abundant pinacoidal face and larger size, respectively. The apparent thicknesses of the crystallite (measured parallel to the electron beam and perpendicular to the pinacoidal faces {0001}, as shown in Figure 16) are predominantly located in the range 70-115 nm, similar to those described for air-quenching in Example 1.

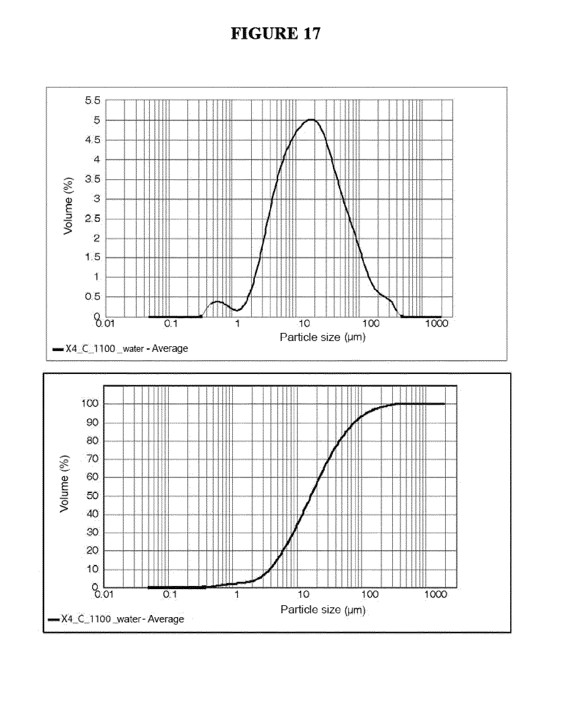

The granulometric distribution of the material examined by FESEM (Figure 17) shows the maximum frequency of the aggregates shifted to a slightly higher value (20 µm) as compared to that observed for the samples obtained by air-quenching from 1100°C, due to the fact that high-energy grinding was not performed.

### Conclusion:

The results of this example allow us to conclude that it is possible to couple the quenching and corundum concentration steps to obtain nanocrystalline corundum by using water-quenching. Moreover, it is observed that this cooling, which is faster than the air-cooling performed in Example 1, makes it possible to obtain corundum crystallites with a similar thickness, with a scant difference in regards to the maximum size distribution of the aggregates obtained by means of air-quenching, subsequent washing and high-energy grinding of Experiment 1.

Given its granulometric distribution (more than 90% below 75 µm), composition (corundum or alpha-alumina) and texture (porous microcrystalline aggregates of nanometric crystals), the product used for the FESEM examination, obtained with limited additional grinding (simple pressure to facilitate spreading on the sample holder adhesive tape), may be classified as a very fine aggregate (close to a filler) of nanocorundum.

### Example 3

### Raw material:

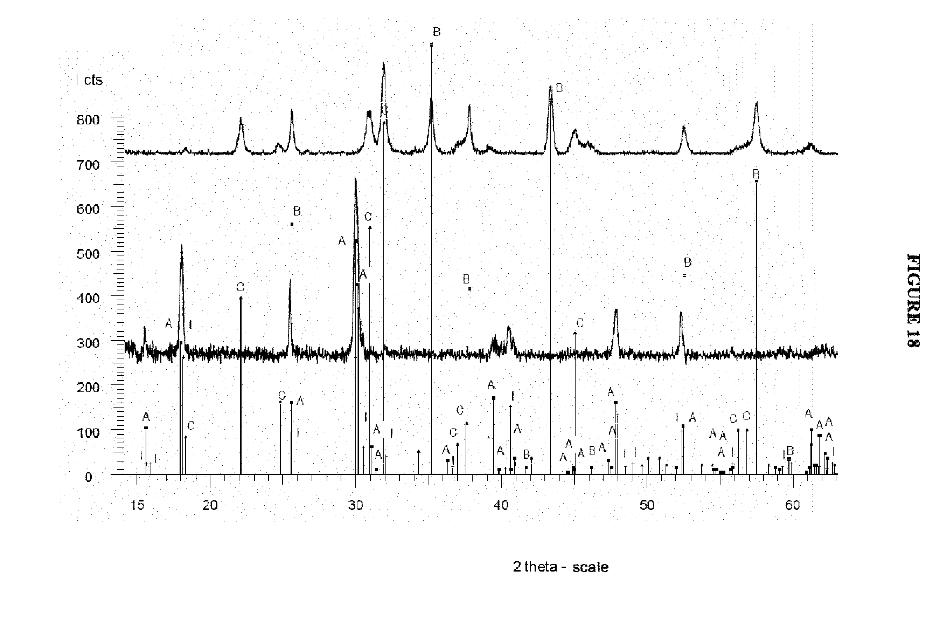

In this third example, a natural alum supplied by a supplier of minerals for art collecting and museums was used, desiccated in a forced-air oven at 35°C for 24 hours. The lower diffractogram in Figure 18 corresponds to the mineral used as the raw material, which was identified as an association of alunite and natroalunite.

### Process:

In this third example, a thermal treatment analogous to that described in Example 1 was performed, whilst also conducting air-quenching and without performing a subsequent concentration of the corundum.

### Result:

As shown by the upper diffractogram in Figure 18, the product is free from sulfates containing Al, and is composed of only corundum and sodium-potassium sulfate (water-soluble salt), which makes it possible to concentrate the corundum by subsequent aqueous washing of the resulting sodium-potassium sulfate co-product.

### Conclusion:

This confirms the possibility of obtaining corundum by the thermal processing of a natural potassium-sodium alum, a type of mineral association that is habitual in natural alunite-natroalunite deposits.

When natural alums are used, a relevant aspect is to adequately control the raw material, in order to prevent contaminants that are not soluble sulfates (very frequently, clayey minerals and quartz) which may be present in the deposit. Materials with such types of impurities should be subjected to a treatment that is less simple and would include, for example, a preliminary step to dissolve the alums and sediment the non-soluble constituents, decant the solution and crystallise it.

## Claims

1. Process for obtaining nanocrystalline corundum, **characterised in that** it comprises:
(a) a first step, of thermal treatment of the raw material used in the process at standard pressure, to a temperature greater than that of the last endothermic accident of the differential thermal analysis record of the raw material, performed to 925°C;
(b) a second step, of quenching from the maximum temperature reached in the preceding step to room temperature, which is performed at a cooling rate equal to or greater than 0.2°C/s.

2. Process according to claim 1, where quenching step (b) is performed by means of a technique selected from a group formed by air extraction, spraying on at least one inert surface, extraction and immersion in water, extraction and immersion in at least one mixture of ice and water, and extraction and immersion in at least one non-flammable fluid at a temperature equal to or less than room temperature, as well as any combination thereof.

3. Process according to any of the preceding claims, where the raw material used in the process involves at least one alum selected from a group formed by potassium alum, sodium alum, potassium-sodium alum, ammonium aluminum sulfate, and hydrated or hydroxylated derivatives of the latter, as well as any combination thereof.

4. Process according to any of the preceding claims, where the raw material used in the process involves at least one synthetic alum obtained from an industrial synthesis process and/or at least one natural alum.

5. Process according to claim 4, where, when the alum is a natural alum, said natural alum results from the treatment of at least one mineral selected from a group formed by alunite, natroalunite, sulfates containing alumina and potash, and sulfates containing alumina and soda, as well as any combination thereof.

6. Process according to one of claims 4 or 5, where, when the raw material used is a natural alum, the process comprises a further step of conditioning or elimination of the impurities present in the raw material.

7. Process according to any of the preceding claims, where, when, in thermal treatment step (a), at least one water-soluble sulfate is generated as a co-product of the corundum, the process in turn comprises a further step of elimination of said soluble sulfate.

8. Process according to claim 7, where said elimination step is performed by dissolving the soluble sulfate in water, followed by a process for separating said solution from the insoluble solid by means of a solid-liquid separation technique.

9. Process according to claim 8, **characterised in that** it further comprises a step for the recovery of the soluble sulfate by means of crystallisation.

10. Process according to any of the preceding claims, where the step of elimination of the water-soluble sulfate is performed simultaneously with quenching step (b), when the latter is performed by means of extraction and pouring in water.

11. Nanocrystalline corundum obtainable from a process according to any of claims 1 to 10.

12. Nanocrystalline corundum according to claim 11, **characterised in that** it comprises primary nanoparticles with tabular or plate shape, with a thickness predominantly less than 100 nm, aggregated in a microcrystalline fine aggregate the granulometric distribution whereof presents a content of less than 10% of aggregates with a size greater than 50 microns.

13. Use of a nanocrystalline corundum according to claims 11 or 12, for the elaboration of re-crystallised nanocorundum products by means of subsequent sintering.

14. Use of a nanocrystalline corundum according to claims 11 or 12, to obtain nanoparticle corundum powders by means of an additional disaggregation step.

15. Use of a nanocrystalline corundum according to claims 11 or 12, as an abrasive, with or without additional disaggregation or mechanical fractionation.

16. Use of a nanocrystalline corundum according to claims 11 or 12, as a functional load or aggregate, with or without additional disaggregation or mechanical fractionation, in plastic polymers or other types of materials.

17. Process according to any of claims 1 to 10, **characterised in that** it comprises a further corundum disaggregation step, to produce a fine aggregate with a content of less than 10% of aggregates with a size greater than 20 microns.

18. Process according to claim 17, where said disaggregation step is performed by means of high-energy grinding.

19. Fine aggregate obtainable from a process according to one of claims 17 or 18.

20. Use of a fine aggregate according to claim 19, as an abrasive or a functional load in plastic polymers or other types of materials.
